# EUROPEAN PATENT APPLICATION

(11) **EP 4 092 724 A1**
(43) Date of publication of application: **23.11.2022**
(21) Application number: 21175158.1
(22) Date of filing: 21.05.2021
(51) Int. Cl.: H01L 21/8234, H01L 21/765, H01L 27/088, H01L 21/8238, H01L 27/092, H01L 29/40, H01L 29/78

(54) **SEMICONDUCTOR DIE WITH A VERTICAL POWER TRANSISTOR DEVICE**

(71) Applicant: Infineon Technologies Austria AG, 9500 Villach (AT)
(72) Inventor: FEIL, Thomas, 9523 Villach (AT)
(74) Representative: König Szynka Tilmann von Renesse Patentanwälte Partnerschaft mbB München

(57) **Abstract**

The disclosure relates to a semiconductor die (1), comprising a vertical power transistor device (2), the vertical power transistor device having a source region (3) and a drain region (4) at opposite sides of a semiconductor body (10), and a lateral transistor device, (20), the lateral transistor device having a body region (21) with a lateral channel region (21.1), as well as a source and a drain region (23, 24) formed at a frontside (10a) of the semiconductor body, wherein a shielding field electrode region (30) with a shielding field electrode (31) is formed in a shielding field electrode trench (32) in the semiconductor body, and wherein at least a portion of the lateral transistor device is arranged vertically above the shielding field electrode region.

## Description

### TECHNICAL FIELD

The present disclosure relates to a semiconductor die comprising a vertical power transistor device.

### BACKGROUND

The vertical power transistor device has a source and a drain region at opposite sides of a semiconductor body. Between, a body region with a channel region is formed, and the current flow can be controlled via a gate region next to the channel region. In addition, a drift region can be formed in the semiconductor body, e. g. vertically between the body and the drain region.

### SUMMARY

It is an object of the present application to provide an improved semiconductor die with a vertical power transistor device, as well as a method of manufacturing the same.

This object is achieved by the semiconductor die of claim 1. Moreover, it is achieved by the method of claim 15. In addition to the vertical device, the die comprises a lateral transistor device, the source and drain region of which are formed at the frontside of the semiconductor body. Moreover, a shielding field electrode trench with a shielding field electrode region is formed in the semiconductor body below the lateral transistor device, wherein at least a portion of the latter is arranged vertically above this shielding field electrode region.

The shielding field electrode can for instance reduce the electrical potential between a backside of the die and the frontside with the lateral device, e. g. reduce the backside drain potential. This can allow for a safe and stable operation of the lateral device, wherein for example a die with a common drain backside for the vertical power device is possible. Generally, the integrated lateral device, monolithically in the same die, can for instance be used to optimize the operational performance of the vertical power device, e. g. by connecting the lateral transistor as a pull-down FET.

In general words, an approach of this application is to combine a vertical power device having its source and drain at opposite sides with a lateral device in the same die, wherein a shielding structure is formed vertically between the lateral device and the backside of the die, which can in particular be a common drain backside of the vertical power device. Particular embodiments and features are presented throughout this disclosure and in the dependent claims. Thereby, the individual features shall be disclosed independently of a specific claim category, the disclosure relates to apparatus and device aspects, but also to method and use aspects. If for instance a device manufactured in a specific way is described, this is also a disclosure of a respective manufacturing process, and vice versa.

Source and drain of the vertical device are arranged at opposite sides of the die, in particular the source region at the frontside and the drain region at the backside. Generally, the channel region of the vertical device can extend vertically, namely be arranged laterally aside a gate region formed for example in a vertical gate trench. In particular, however, the channel can extend laterally and, in consequence, be aligned vertically with the gate region, see in detail below. This lateral gate of the vertical device can in particular be combined with a vertical field electrode trench, wherein at least a portion of the lateral gate and channel region of the vertical device can be arranged above the field electrode trench, see in detail below. Providing the vertical device with a lateral gate can for instance simplify the integration of the lateral device into the same die, e. g. allow for a certain process integration ("re-use" of one or more power device process steps for the lateral device).

"Vertical" or "vertically" refer to the vertical direction, which lies for instance perpendicular to a surface of the die, e. g. the surface of a substrate or an epitaxial layer formed on the substrate. "Above" means vertically aligned and closer to the frontside of the die, and "below" means vertically aligned and closer to the backside. "Lateral" or "laterally" refer to the lateral directions perpendicular to the vertical direction, in which for instance the die area is taken. Independently of whether the vertical or the lateral device is referred to, a respective "gate region" comprises a gate electrode and a gate dielectric, the latter capacitively coupling the gate electrode to the channel region. Likewise, a respective "field electrode region" comprises a field electrode and a field dielectric, the latter capacitively coupling the field electrode, e. g. to a drift region of the device. The shielding field electrode is arranged in the shielding field electrode trench, which can in particular be etched into a lower semiconductor body and be covered by an upper epitaxial layer. "At least a portion" of the lateral device is arranged above the shielding field electrode region, e. g. at least the source region and/or body region and/or drain region of the lateral device.

In an embodiment, a well region is formed laterally aside the shielding field electrode trench and is doped with an opposite conductivity type as the source and drain region of the vertical power device. The well region can in particular be electrically connected to the source region of the vertical device, it can reduce or compensate the backside potential, in particular the drain potential of the power device. Above the well region, at least a portion of the lateral transistor device can be arranged, e. g. its source or drain region, the other region being arranged above the shielding field electrode region.

Seen in a vertical cross-section, the well region can be formed laterally between two neighbouring shielding field electrode regions, e. g. extend from the sidewall of one shielding field electrode trench to a sidewall of the other trench. The lower end of the well region can for instance be arranged at a larger vertical height (closer to the frontside) than a lower end of the neighbouring trench or trenches. Vertically below the well region, e. g. still between the trenches, the semiconductor body can be doped with the same charge carrier type as in the source and the drain region of the vertical device. With a respective additional implant region below the well, the potential or electrical field can decline over the vertical extension of the additional implant and well region upwards, resulting for example in a basically field-free situation at its upper end. In the exemplary embodiments, power source and drain are n-doped, the well region is a p-well, and the additional implant region is n-doped.

In an embodiment, a field electrode trench, in which a field electrode of the vertical power device is formed, and the shielding field electrode trench have a different vertical depth and/or different lateral width. The shielding field electrode trench can for instance be deeper and/or wider than the power device trench, in particular both. The width can for example be taken in a lateral direction which defines a translational symmetry for cells of the power device. The trenches of the power device and those below the lateral transistor device can be etched in a common process step, wherein for instance a wider opening in an etch mask, which defines a wider trench, can also relate to a deeper trench due to the better etch attack. A wider and/or deeper trench below the lateral device can for instance reduce or compensate a higher backside potential (e. g. assuming the same pitch), whereas a narrow trench of the vertical power device can be advantageous in terms of the area use and die size.

In an embodiment, a bridge implant region is formed below the drift region of the vertical power device, made of the same conductivity type but with a higher dopant concentration than the drift region. The concentration can for instance lie between the drift and the drain region, e. g. close to the latter. With the bridge implant region, the drain region formed at the backside of the die can be lifted, which can avoid an Rₒₙ • A increase. A thicker semiconductor body, in particular thicker lower epitaxial layer (see below), can for instance be advantageous in view of wider/deeper trenches below the lateral device.

In an embodiment, the lateral device comprises a lateral drift region, which is formed between the lateral channel and the drain region. It is made of the same conductivity type as the drain region of the lateral device, but with a lower doping concentration. If the lateral device is a p-MOS, its drift region can be p-doped. For a field shaping, an electrode can capacitively couple to the drift region of the lateral device via a lateral field dielectric. In an embodiment, this lateral field dielectric is thicker than a lateral gate dielectric capacitively coupling the gate electrode of the lateral device to its channel region.

In general, one single electrode can form the lateral gate electrode and the lateral field electrode, so that the latter is on gate potential and for instance coupled via a thicker field dielectric to the drift region (see above). In a particular embodiment, however, the lateral field electrode is electrically isolated from the lateral gate electrode. Depending on the application, the lateral field electrode can for instance be connected to the source region of the lateral device, or it can be controlled separately.

In an embodiment, a source and/or a drain contact of the lateral transistor device extends through an insulating layer formed on the semiconductor body, e. g. a silicon oxide or borophosphosilicate glass (BPSG) layer. The contact or contacts intersect the insulating layer, connecting the respective region for instance to a wiring or metallization layer formed above. The contact or contacts are made of an electrically conductive material, in particular metal, for instance tungsten. To improve the connection to the respective region, e. g. an n+- or p+-implantation can be introduced adjacent to the contact (n+ in an n-region, and p+ in a p-region), for example via a respective mask.

In an embodiment, a first one of the contacts is arranged vertically above the shielding field electrode region and/or a second one of the contacts is arranged on a lateral position between two shielding field electrode trenches. Seen in a vertical cross-section, in particular a symmetrical design is possible, e. g. with one second contact centrally and two first contacts above the two shielding field electrode regions (one first contact above each region).

Independently of these details, the first contact arranged above the shielding field electrode region can in particular be arranged vertically above the shielding field electrode, e. g. centrally above the shielding field electrode trench. Generally, an insulating spacer can be formed in the shielding field electrode trench, covering the electrode upwards. The first contact can extend through the insulating spacer. Seen in a vertical cross-section, it can end above the insulating spacer, e. g. inside the body region, which can enable a good contact formation at the bottom of the contact. Alternatively, the contact can extend down to the insulating spacer, ending for instance on the latter, namely at an upper end of the insulating spacer. As a further alternative, the contact can extend into the spacer but end above the field electrode. In any of these cases, the field electrode and the contact are, seen in a vertical cross-section, electrically isolated from each other. This can for instance decouple switching events of the vertical power device from the lateral transistor device. Depending on the specific design, the first can be a source contact and the second one a drain contact, or the first contact can be a drain contact and the second one a source contact. This applies for both, independently of whether an n-MOS or a p-MOS is formed.

In an embodiment, the well region discussed above is electrically connected to the source contact or to the drain contact of the lateral device. In other words, in particular, the source or the drain region of the lateral device can be electrically connected to the source region of the vertical power device.

In an embodiment, the shielding field electrode trench extends from a frontside of a lower semiconductor body into the latter, wherein an upper epitaxial layer is formed on the frontside of the lower semiconductor body. The lower semiconductor body can for instance comprise a semiconductor substrate and a lower epitaxial layer deposited onto the substrate, in which for instance a drift region of the vertical device can be formed. In the area of the lateral device, e. g. the well region, in particular the p-well, can be formed in the lower epitaxial layer. Optionally, the additional implant region can be formed below the well region. The different doping of the lower epitaxial layer in the areas of the vertical and the lateral device can for instance be achieved with a respective masking in an implantation subsequent to the epitaxial deposition of the layer (e. g. in combination with an in situ doping during the deposition or as an alternative).

The trench or trenches, in particular the shielding field electrode trench for the lateral device and field electrode trenches for the vertical device, are etched into the lower semiconductor body, in particular into the lower epitaxial layer. The trench or trenches can in particular extend solely in the lower semiconductor body, particularly solely in the lower epitaxial layer. After forming the field electrode regions, the upper epitaxial layer can be deposited onto the frontside of the lower semiconductor body, in particular onto the lower epitaxial layer.

In the upper epitaxial layer, e. g. above the shielding field electrode trench and the well region, the lateral device can be formed. In particular, the source, body and drain region of the lateral device can be formed by respective implantations in the upper epitaxial layer. The lateral gate region can be formed subsequently on the upper epitaxial layer, e. g. by depositing and structuring a field dielectric layer and depositing and structuring a field electrode layer. In case of a lateral device with a lateral drift region (see above), a thicker dielectric and/or separate field electrode can be formed above).

In an embodiment, the vertical power device comprises a lateral channel and gate region, wherein the former can in particular be formed in the upper epitaxial layer. Due to the lateral design, the gate and the channel region are vertically aligned, in particular the gate region above the channel region. Particularly, at least a portion of the lateral channel and gate region can be arranged above a field electrode region of the vertical device, seen in a vertical cross-section e. g. a portion of at least 30%, 50%, 70% or 90%, in particular the whole channel region can be vertically aligned with the field electrode region. As illustrated in the exemplary embodiments in detail, the vertical device can in particular comprise a first gate region formed above a first side of the field electrode region or trench, and it can comprise a second gate region formed above a second side thereof, the first side lying at a first sidewall and the second side lying at a laterally opposite second sidewall of the field electrode trench of the vertical device, seen in a vertical cross-section.

Generally, the lateral channel and gate region of the vertical device, and in particular the at least proportional arrangement above the field electrode trench, can allow for an efficient area use. With a vertical channel, which can be an alternative in general, the possibilities for a further lateral shrink can be limited, e. g. because the field electrode trench itself requires a certain lateral width. This limitation can be circumvented at least to some extent by arranging the channel region of the vertical power device above the field electrode trench. Providing not only the lateral but also the vertical transistor device with a lateral gate region can also allow for a certain process integration, e. g. a simultaneous formation of the gate dielectrics and/or the gate electrodes of the vertical and the lateral device.

In an embodiment, a second lateral transistor device is formed in the semiconductor die in addition to the first lateral transistor device. Like the latter, the second lateral device can be formed above a shielding field electrode region and/or a well region. Generally, any embodiment described for the first lateral device shall also be disclosed for the second lateral device. In particular, the first and the second lateral device can be of an opposite majority charge carrier type, one being a p-MOS and the other one being an n-MOS. These devices can for instance be connected as a CMOS structure, allowing e. g. the integration of a certain logic function. To form for instance an inverter, the gate regions of the two devices can be connected as an input, and their drain regions as an output.

As mentioned, the application relates also to a method of manufacturing a semiconductor die disclosed here. It can comprise the steps:
i) etching the shielding field electrode trench;
ii) forming the shielding field electrode region with the shielding field electrode, and, subsequently,
iii) forming the lateral transistor device.

Regarding further possible details, reference is made to the description above and to the exemplary embodiments. In particular, in step i), the field electrode trench of the vertical device can be etched simultaneously. Alternatively or in addition, when in step iii) the lateral gate region of the lateral device is formed, a lateral gate region of the vertical device can be formed simultaneously, see above.

### BRIEF DESCRIPTION OF THE DRAWINGS

Below, the semiconductor die with the vertical and lateral devices and the manufacturing are explained in further detail by means of exemplary embodiments. Therein, the individual features can also be relevant in a different combination.
- Figure 1: shows a portion of a semiconductor die with vertical and lateral devices;
- Figure 2: shows a first design of a lateral device in a detailed view;
- Figure 3: shows a second design of a lateral device in a detailed view;
- Figure 4: shows a third design of a lateral device in a detailed view;
- Figure 5: shows a fourth design of a lateral device in a detailed view;
- Figure 6: illustrates two lateral devices in a CMOS structure;
- Figure 7a-d: illustrate some manufacturing steps;
- Figure 8: summarizes some manufacturing steps in a flow diagram.

### DETAILED DESCRIPTION

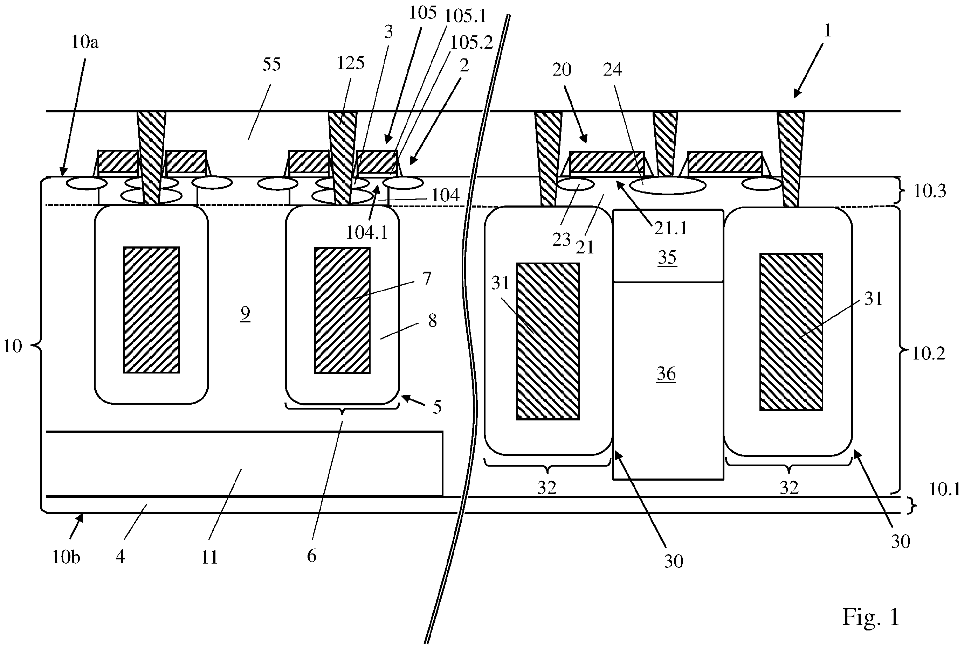

Figure 1 illustrates a semiconductor die 1 with a vertical power transistor device 2. It has a source region 3 formed at a frontside 10a and a drain region 4 formed at a backside 10b of a semiconductor body 10. Though being a vertical device with the source and the drain region 3, 4 at opposite sides 10a, b, a channel region 104.1 formed in a body region 104 of the vertical power device 2 extends laterally. For an efficient area use, it is arranged vertically above a field electrode region 5 formed in a field electrode trench 6. The latter extends into a drift region 9 and comprises a field electrode 7 and a field dielectric 8.

On the frontside 10a of the semiconductor body 10, an insulating layer 55 is arranged, e. g. a silicon oxide layer. It is intersected by a contact 125 of the vertical device 2, which is arranged vertically above the field electrode 7. The contact 125 electrically connects the source region 3 to a frontside metallization (not shown). On the frontside 10a, covered by the insulating layer 55, a gate region 105 is arranged, it comprises a gate electrode 105.1 and a gate dielectric 105.2.

In addition to the vertical device 2, a lateral device 20 is formed in the die 1. It has a body region 21 with a lateral channel region 21.1, as well as a source and a drain region 23, 24. Due to the lateral design, the source and the drain region 23, 24 are both arranged at the frontside 10a of the semiconductor body 10. They are formed in an upper epitaxial layer 10.3, in which also the source region 3 and body region 104 of the vertical device 2 are arranged.

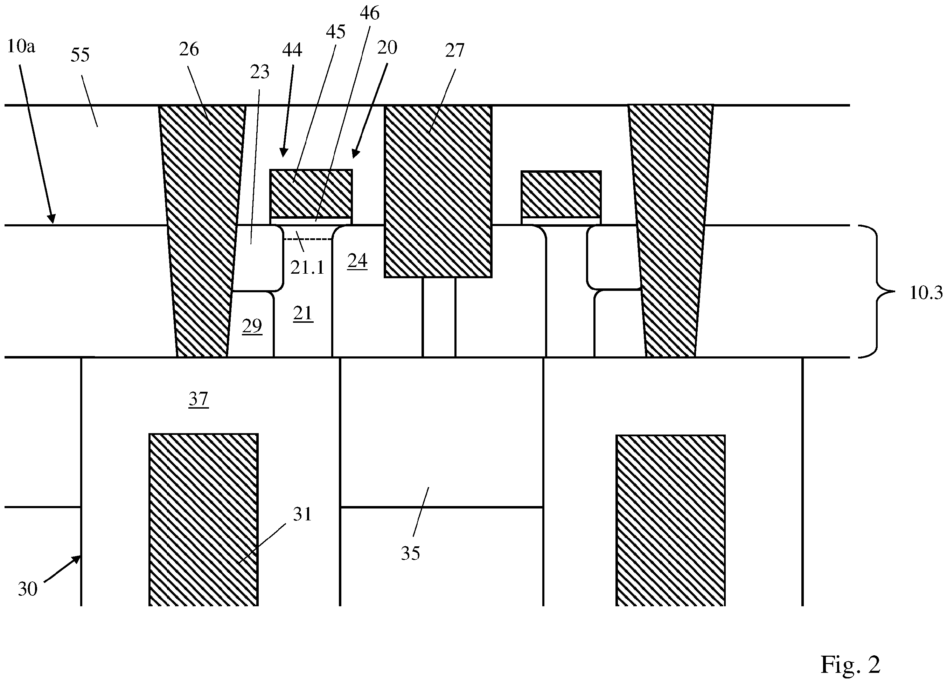

Below the lateral device 20, in a lower semiconductor body 10.1, 10.2, in particular in a lower epitaxial layer 10.2, a shielding field electrode region 30 with a shielding field electrode 31 is formed in a shielding field electrode trench 32. The shielding field electrode or electrodes 31 shield the lateral device 20 with respect to the backside 10b, namely with respect to the backside drain potential, which can enable a common drain backside. The shielding field electrodes 31 can be contacted outside the sectional plane shown, e. g. outside the cell of the lateral device. Between the shielding field electrode trenches 32, a well region 35 is arranged, which is electrically connected to the vertical power FET source, see in detail figure 2. In addition, an additional implant region 36 can be formed below the well region to optimize the breakdown voltage.

The shielding field electrode trenches 32 have a larger lateral width than the field electrode trenches 6 of the vertical device 2. In consequence, since these trenches 6, 32 are in particular etched simultaneously, the shielding field electrode trenches 32 can extend deeper into the semiconductor body 10, in particular the lower epitaxial layer 10.2. To shorten a vertical current path in the drift region 9 of the vertical device 2, a bridge implant region 11 is formed below its field electrode trenches 6, namely between the drift region 9 and the drain region 4. It is of the same conductivity type as the drift region 9, n-type in this example, but has a higher doping concentration.

Figure 2 illustrates a first design of the lateral device 20 integrated into the die 1 in a detailed view. Above the body region 21 with the channel region 21.1 formed between the source and drain region 23, 24, a lateral gate region 44 of the device 20 is arranged, comprising a lateral gate electrode 45 and a lateral gate dielectric 46. The gate region 44 is covered by the insulating layer 55 formed on the frontside 10a of the semiconductor body 10. The insulating layer 55 is intersected by a source contact 26 connecting the source region 23 to a metallization layer above (not shown). In addition, the source contact 26 contacts the body region 21 via a highly doped body contact region 29. In the example shown, the contact 26 extends through the upper epitaxial layer 10.3 and ends on an insulating spacer 37 formed in the shielding field electrode trench 30 above the shielding field electrode 31. Alternatively, it can end above, e. g. inside the body contact region 29.

The drain region 24 is contacted via a drain contact 27 extending through the insulating layer 55 and into the upper epitaxial layer 10.3. In the example shown, the source contact 26 is arranged vertically above the shielding field electrode 31, and the drain contact 27 is arranged on a lateral position between the shielding field electrode trenches 32. The device 20 is a p-MOS in this example, the source and the drain region 23,24 being p-doped and the body region 21 being n-doped. The region centrally below the drain contact 27, which is not referenced with a numeral, is a residuum from manufacturing, namely of a stop island made for instance of silicon nitride and used when planarizing the upper epitaxial layer 10.3. Alternatively, it could be removed completely, the drain region 24 extending laterally over the whole distance below the drain contact 27.

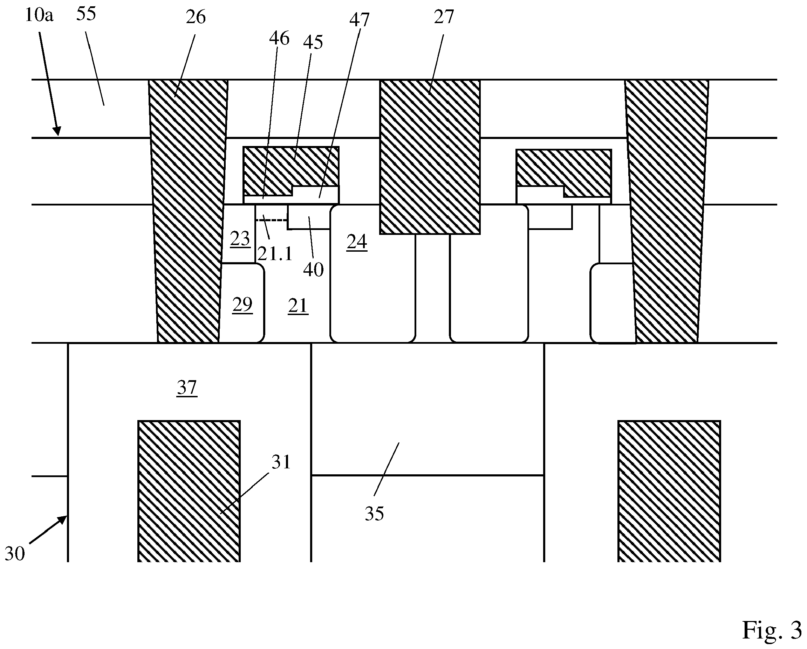

Figure 3 illustrates an alternative design of the lateral device 20. Generally, in this disclosure, the same reference numerals are used for the same features or features having the same function, and reference is made to the respectively other figures. The device 20 of figure 3 differs from figure 2 in that it comprises additionally a lateral drift region 40 formed between the drain region 24 and the channel region 21.1. Like the source and the drain region 23,24 the drift region 40 is p-doped but with a lower doping concentration. In this example, no separate field electrode is provided, instead the lateral gate electrode 45 capacitively couples to the lateral drift region 40. Therein, a lateral field dielectric 47 is thicker than the lateral gate dielectric 46.

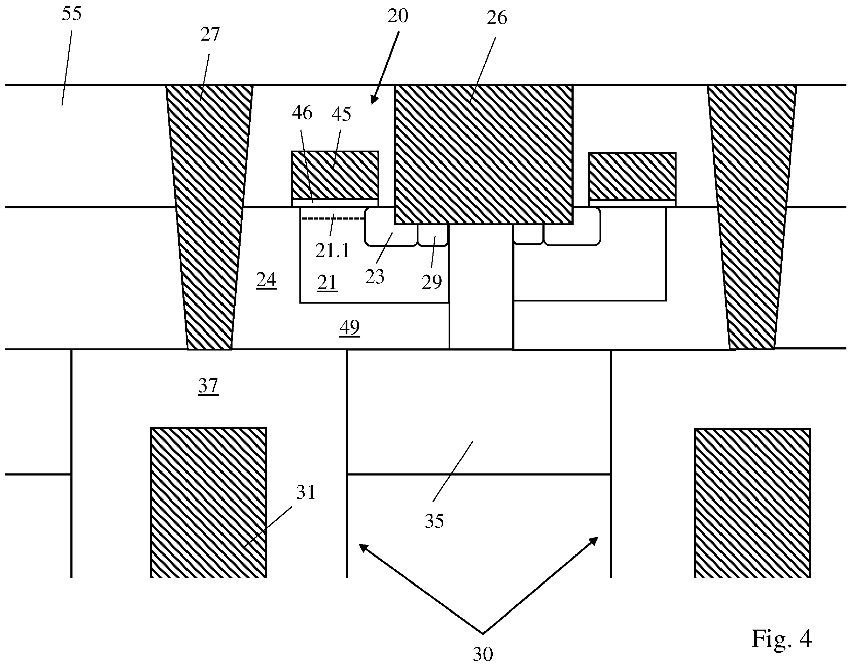

In the device 20 of figure 4, in contrast to figures 2 and 3, the source region 23 and the source contact 26 are arranged laterally between the trenches 30, and the drain region 24 with the drain contact 27 is arranged vertically above the shielding field electrode 31. Like in figures 2 and 3, the well region 35 is connected to the drain region 24, a lateral implant region 49 being provided for that purpose. It is p-doped, like the source and the drain region 23, 24 and the well region 35. In the design of figure 4, the highly doped body contact region 29 is arranged below the source contact 26.

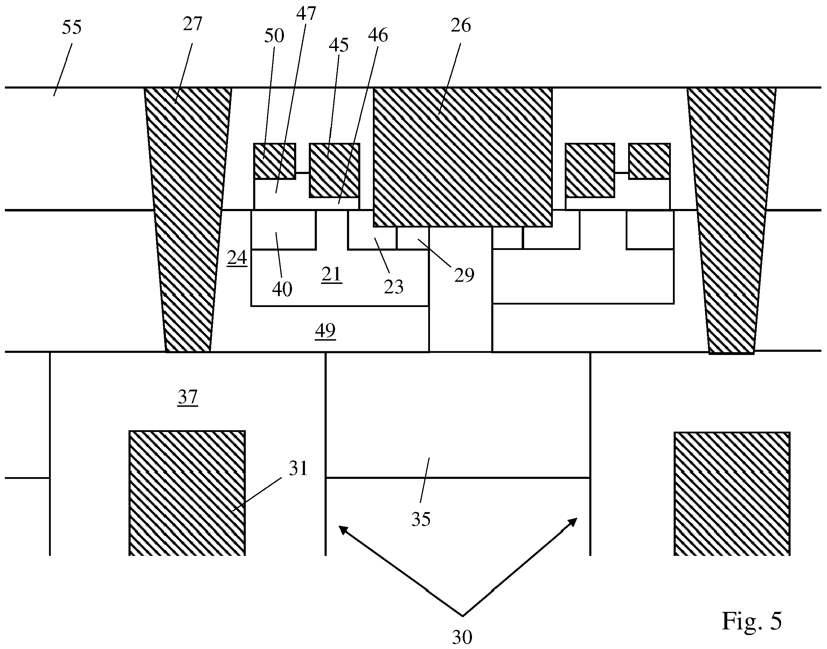

The device 20 of figure 5 differs from figure 4 in that it comprises in addition a lateral drift region 40, which is p-doped like the drain region 24 but with a lower doping concentration. Above the lateral drift region 40, a lateral field electrode 50 is formed, coupling via a lateral field dielectric 47 which is thicker than the lateral gate dielectric 46. The lateral field electrode 50 is electrically isolated from the lateral gate electrode 45, it can for instance be connected to source (outside the drawing plane) or operated separately.

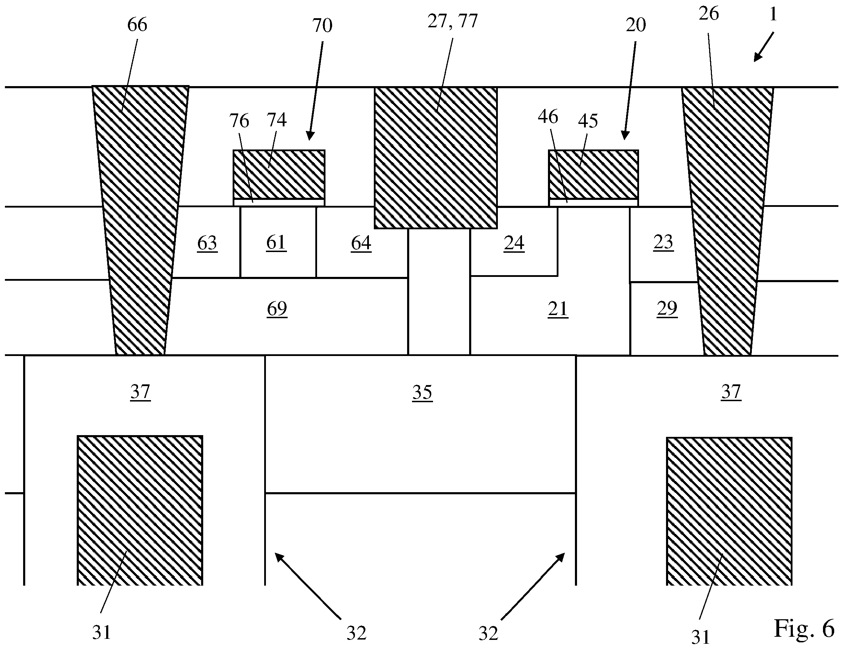

Figure 6 illustrates an additional lateral transistor device 70 formed together with the (first) lateral transistor device 20 and the vertical power device (not shown) in the die 1. Regarding the design of the first lateral transistor device 20, reference is made to figure 2. It is a p-MOS, the source and drain region 23, 24 being p-doped and the body region 21 n-doped. The additional transistor device 70 is an n-MOS, its source region 63 being n-doped like the drain region 64, and the body region 61 being p-doped. A source contact 66 of the p-MOS is formed above the shielding field electrode 31, it additionally contacts a highly p-doped body contact region 69.

The source contact 26 of the p-MOS is formed above the neighbouring field electrode 31, its drain contact 27 is formed on a lateral position between the trenches 32. This contact serves also as a drain contact 77 of the n-MOS, the devices 20, 70 are connected as a CMOS structure, forming in particular an inverter. A gate electrode 74 of the n-MOS capacitively coupling via a gate dielectric 76 is electrically connected to the gate electrode 45 outside the drawing plane or in a metallization layer above (not shown).

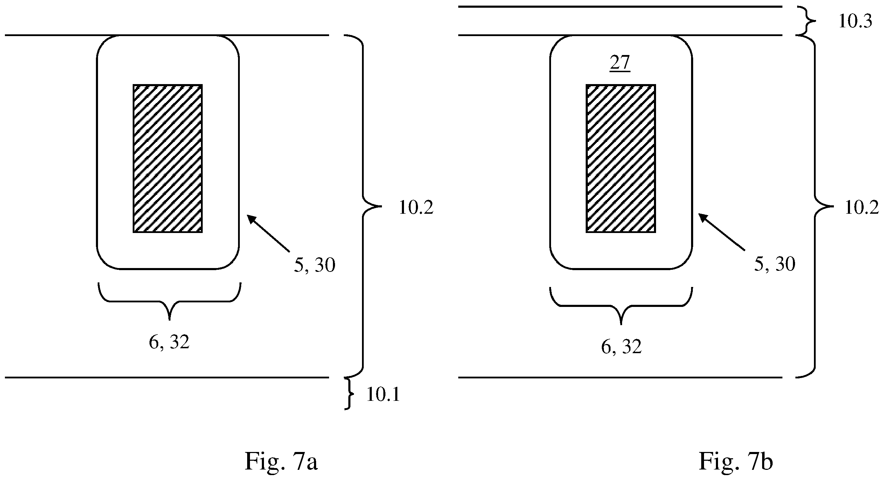

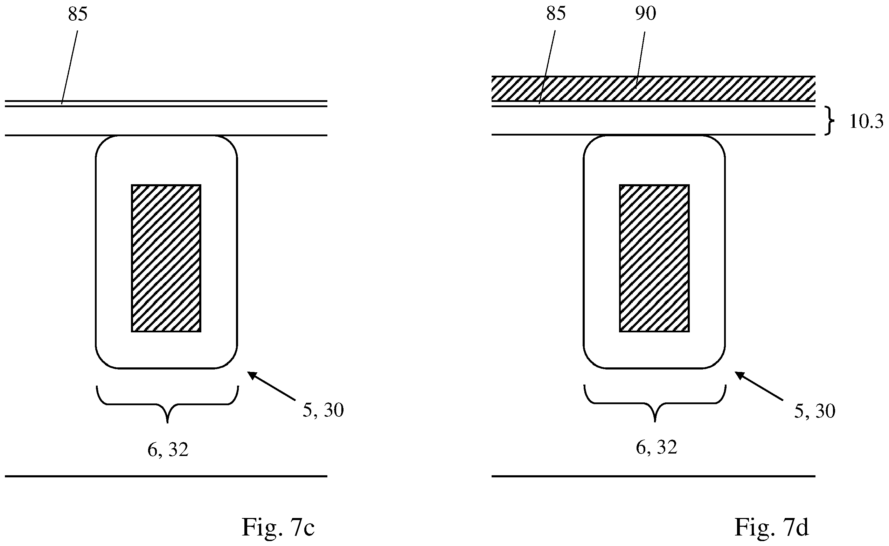

Figures 7a-d illustrate some manufacturing steps that can apply for both, the vertical and the lateral device. In figure 7a, the respective trench 6, 32 has been etched into the lower epitaxial layer 10.2, and the respective field electrode region 5, 30 has been formed. Then, the upper epitaxial layer 10.3 is deposited, covering the respective trench 6, 32, see figure 7b. Subsequently, a dielectric layer 85 is deposited (figure 7c), followed by a deposition of an electrically conductive layer 90. By structuring the latter, e. g. prior to the deposition by a mask or in a subsequent etch back step, the gate electrode or electrodes can be defined. The dielectric layer 85 defines the gate dielectric, it can be removed from other locations of the die in an etch back step after the gate electrode formation. Implantations forming the different regions in the upper epitaxial layer 10.3 can be performed in between steps 7b and c and/or after the gate electrode formation. The upper epitaxial layer 10.3 can be doped in situ or in particular after its deposition to form the regions required for the respective device.

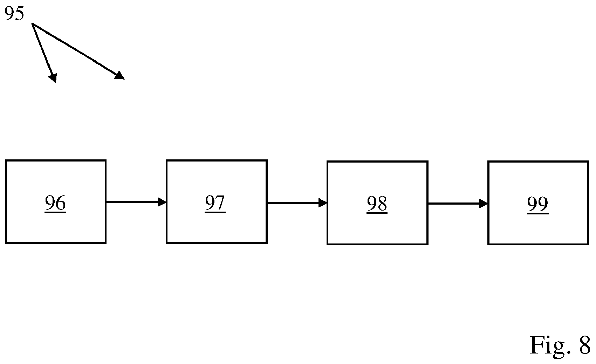

Figure 8 shows a flow diagram illustrating some manufacturing steps 95. After etching 96 the shielding field electrode trench, the shielding field electrode region is formed 97. Subsequently, the well region can be formed 98, prior to forming 99 the lateral transistor device above.

## Claims

1. A semiconductor die (1), comprising
a vertical power transistor device (2),
the vertical power transistor device (2) having a source region (3) and a drain region (4) at opposite sides (10a,b) of a semiconductor body (10), and
a lateral transistor device (20),
the lateral transistor device (20) having a body region (21) with a lateral channel region (21.1), as well as a source and a drain region (23, 24) formed at a frontside (10a) of the semiconductor body (10),
wherein a shielding field electrode region (30) with a shielding field electrode (31) is formed in a shielding field electrode trench (32) in the semiconductor body (10), and wherein at least a portion of the lateral transistor device (20) is arranged vertically above the shielding field electrode region (30).

2. The semiconductor die (1) of claim 1, wherein a well region (35) is formed in the semiconductor body (10) laterally aside the shielding field electrode trench (32), the well region (35) doped with an opposite conductivity type as the source and the drain region (3, 4) of the vertical power transistor device (2) and electrically connected to the source region (3) of the vertical power transistor device (2).

3. The semiconductor die (1) of claim 1 or 2, the vertical power transistor device (2) comprising a field electrode region (5) with a field electrode (7) formed in a field electrode trench (6), wherein the field electrode trench (6) of the vertical power transistor device (2) and the shielding field electrode trench (32) differ from each other in at least one of their respective vertical depth and their respective lateral width.

4. The semiconductor die (1) of any one of the preceding claims, the semiconductor body (10) comprising a semiconductor substrate (10.1) and a lower epitaxial layer (10.2), wherein a drift region (9) of the vertical power transistor device (2) is formed in the lower epitaxial layer (10.2), and wherein a bridge implant region (11) is formed at a lower end of the lower epitaxial layer (10.2), the bridge implant region (11) made of the same conductivity type as the drift region (9) but with a higher doping concentration than the latter.

5. The semiconductor die (1) of any one of the preceding claims, wherein the lateral transistor device (20) comprises a lateral drift region (40), which is arranged laterally between the lateral channel region (21.1) and the drain region (24) of the lateral transistor device (20), the drift region (40) made of the same conductivity as the drain region (24) with a lower doping concentration than the latter.

6. The semiconductor die (1) of claim 5, wherein a lateral field dielectric (47) formed vertically above the lateral drift region (40) has a greater vertical thickness than a lateral gate dielectric (46) formed vertically above the channel region (21.1).

7. The semiconductor die (1) of claim 6, wherein a lateral field electrode (50) is formed above the lateral field dielectric (47), the lateral field electrode (50) being electrically isolated from a lateral gate electrode (45) formed vertically above the lateral gate dielectric (46).

8. The semiconductor die (1) of any one of the preceding claims, an insulating layer (55) formed on the semiconductor body (10), wherein a source contact (26) electrically contacting the source region (23) of the lateral transistor device (20) and a drain contact (27) electrically contacting the drain region (24) of the lateral transistor device (20) extend through the insulating layer (55), wherein a first one of the contacts (26,27) is arranged vertically above the shielding field electrode region (30).

9. The semiconductor die (1) of claim 8, an insulating spacer (37) being formed vertically above the shielding field electrode (31) in the shielding field electrode trench (32), wherein the first contact extends to the insulating spacer (37).

10. The semiconductor die (1) of claim 8 or 9, wherein a second one of the contacts (26,27) is arranged on a lateral position between the shielding field electrode trench (32) and an additional shielding field electrode trench (32).

11. The semiconductor die (1) of claim 2 in combination with any one of claims 8 to 10, wherein the well region (35) is electrically connected to the source contact (26) or the drain contact (27) of the lateral transistor device (20).

12. The semiconductor die (1) of any one of the preceding claims, wherein the shielding field electrode region (30) is formed in a lower semiconductor body (10.1,10.2), the shielding field electrode trench (32) extending from a frontside of the lower semiconductor body (10.1,10.2) into the latter, wherein the source, the body and the drain region (21,23,24) of the lateral transistor device (20) are formed in an upper epitaxial layer (10.3) deposited onto the lower semiconductor body (10.1,10.2).

13. The semiconductor die (1) of claim 12, wherein the source region (3) and a channel region of the vertical power transistor device (2) are formed in the upper epitaxial layer (10.3).

14. The semiconductor die (1) of any one of the preceding claims, in which an additional lateral transistor device (70) is formed, the lateral transistor devices (20,70) being of an opposite majority charge carrier type and being electrically connected as a CMOS structure.

15. A method of manufacturing the semiconductor die (1) of any one of the preceding claims, comprising the steps:
i) etching (96) the shielding field electrode trench (32);
ii) forming (97) the shielding field electrode region (30) with the shielding field electrode (31),
and, subsequently,
iii) forming (99) the lateral transistor device (20).
